# EUROPEAN PATENT APPLICATION

(11) **EP 2 296 192 A1**
(43) Date of publication of application: **16.03.2011**
(21) Application number: 09773426.3
(22) Date of filing: 29.06.2009
(51) Int. Cl.: H01L 31/075

(54) **SOLAR CELL AND METHOD OF MANUFACTURING THE SAME**

(30) Priority: 30.06.2008 JP 2008171323
(71) Applicant: SANYO Electric Co., Ltd., Moriguchi-shi Osaka 570-8677 (JP)
(72) Inventor: ASAUMI, Toshio, . (JP); SAKATA, Hitoshi, . (JP)
(74) Representative: Calderbank, Thomas Roger
(86) International application number: PCT/JP2009/061831
(87) International publication number: WO 2010/001848

(57) **Abstract**

In a solar cell comprising a semiconductor substrate 11 and a i-type amorphous semiconductor layer 12 formed on a back surface of the semiconductor substrate 11, the i-type amorphous semiconductor layer 12 includes an exposed portion 12A exposed in a planer view, and a covered portion 12B covered with each of the p-type semiconductor layer 13 and the n-type semiconductor layer 14. A thickness T₁ of the exposed portion 12A is less than a thickness T₂ of the covered portion 12B.

## Description

### Technical Field

The present invention relates to a back-junction solar cell including an n-type semiconductor layer and a p-type semiconductor layer formed on a back surface of a semiconductor substrate, and to a method of manufacturing the same.

### Background Art

Solar cells have been expected to be a new energy source, since the solar cells can directly convert clean and inexhaustibly-supplied sunlight into electricity.

There has heretofore been disclosed a so-called back-junction solar cell including an n-type semiconductor layer and a p-type semiconductor layer formed on a back surface of a semiconductor substrate (see Japanese Patent Application Publication No. 2005-101240). Specifically, the n-type semiconductor layer and the p-type semiconductor layer are formed into alternately-arranged line patterns on a substantially intrinsic amorphous semiconductor layer formed on the back surface of the semiconductor substrate. The substantially intrinsic amorphous semiconductor layer has a passivation property that suppresses recombination of carriers on the back surface of the semiconductor substrate.

However, since the amorphous semiconductor layer has electric conductivity, a short circuit may occur between the n-type semiconductor layer and the p-type semiconductor layer. In particular, this short circuit is more likely to occur when a distance between the n-type semiconductor layer and the p-type semiconductor layer is reduced for the purpose of improving carrier collection efficiency.

Meanwhile, the amorphous semiconductor layer may be provided only between the semiconductor substrate and each of the n-type and the p-type semiconductor layers. However, in this case, the passivation property on the back surface of the semiconductor substrate is degraded.

The present invention has been made in view of the foregoing circumstances, and an objective thereof is to provide a back-junction solar cell and a method of manufacturing the same, which are capable of suppressing occurrence of a short circuit in an amorphous semiconductor layer formed on a back surface of a semiconductor substrate.

### Summary of the Invention

A solar cell having a aspect of the present invention is characterized as comprising: a semiconductor substrate having a light receiving surface and a back surface provided on an opposite side of the light receiving surface; a amorphous semiconductor layer, substantially intrinsic, and formed on the back surface; a p-type semiconductor layer formed on the amorphous semiconductor layer; and an n-type semiconductor layer formed on the amorphous semiconductor layer, wherein the amorphous semiconductor layer includes an exposed portion exposed in a planer view from the back surface side, and a covered portion covered with each of the p-type semiconductor layer and the n-type semiconductor layer in the planer view, and a first thickness being a thickness of the exposed portion is less than a second thickness being a thickness of the covered portion.

According to the solar cell having the aspect of the present invention, in a parallel direction to the back surface of the semiconductor substrate, electrical resistance of the exposed portion can be made larger than electrical resistance of the covered portion. For this reason, occurrence of a short circuit can be suppressed between the p-type amorphous semiconductor layer formed on one covered portion and the n-type amorphous semiconductor layer formed on another covered portion. Moreover, there are formed not only the covered portion but also the exposed portion on the back surface of the semiconductor substrate. For this reason, the passivation property of the i-type amorphous semiconductor layer can be maintained on the back surface of the semiconductor substrate.

In the solar cell having the aspect of the present invention, a ratio of the first thickness relative to the second thickness is preferably 0.48 or more but less than 1.

In the solar cell having the aspect of the present invention, the first thickness is preferably 1.44 nm or more but less than 25 nm.

A method of manufacturing a solar cell having a aspect of the present invention is summarized as including a semiconductor substrate having a light receiving surface and a back surface provided on an opposite side of the light receiving surface, the method comprising the steps of: forming a first amorphous semiconductor layer substantially intrinsic on the back surface; forming a second amorphous semiconductor substantially intrinsic on a first region and on a second region provided on a surface of the first amorphous semiconductor layer; forming a p-type semiconductor layer on the second amorphous semiconductor layer formed on the first region; and forming an n-type semiconductor layer on the second amorphous semiconductor layer formed on the second region.

### Brief Description of the Drawings

[Fig. 1] Fig. 1 is a plan view of a solar cell 10 according to an embodiment of the present invention which is viewed from a back surface side.
[Fig. 2] Fig. 2 is an enlarged cross-sectional view taken along an A-A line in Fig. 1.
[Fig. 3] Fig. 3 is a view for explaining a method of manufacturing the solar cell 10 according to the embodiment of the present invention.
[Fig. 4] Fig. 4 is a view for explaining a method of manufacturing the solar cell 10 according to the embodiment of the present invention.
[Fig. 5] Fig. 5 is a view for explaining a method of manufacturing the solar cell 10 according to the embodiment of the present invention.
[Fig. 6] Fig. 6 is a graph showing relations between layer thicknesses of i-type amorphous Si layers and solar cell characteristics.
[Fig. 7] Fig. 7 is a graph showing relations between ratios (T₁/T₂) and the solar cell characteristics. Embodiment Modes for Carrying Out the Invention

Next, embodiments of the present invention will be described using the drawings. In description of the drawings below, identical or similar reference numerals will be given to identical or similar parts. However, it should be noted that the drawings are schematic and a dimensional ratio and the like is different from actual ones. Accordingly, specific sizes or the like should be determined in consideration of the description below. Moreover, needless to say, there are some differences in dimensional relations and ratios between the mutual drawings.

### (Configuration of Solar Cell)

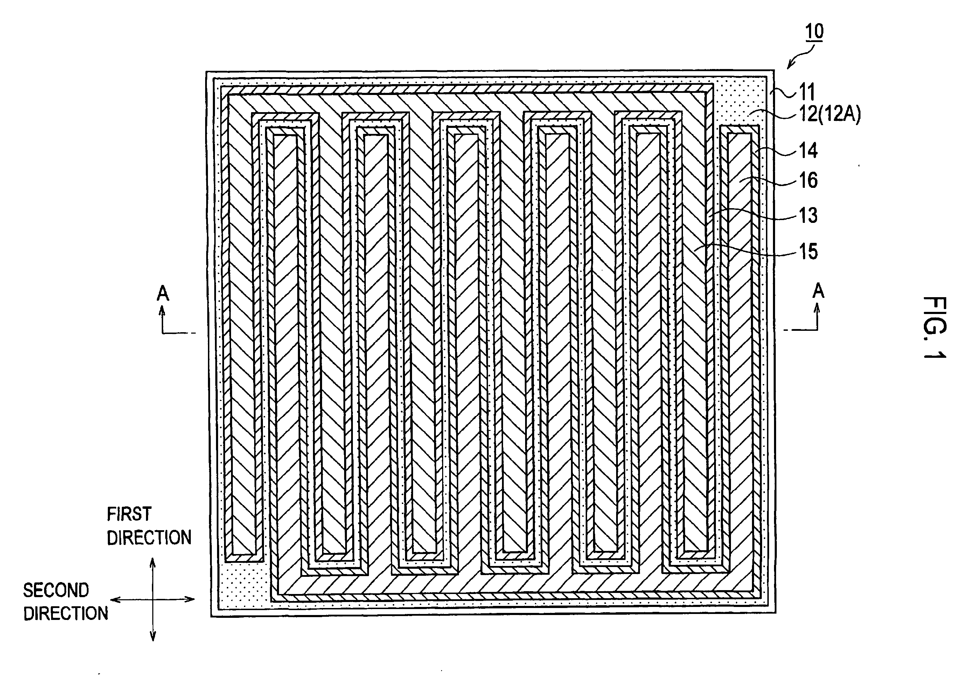

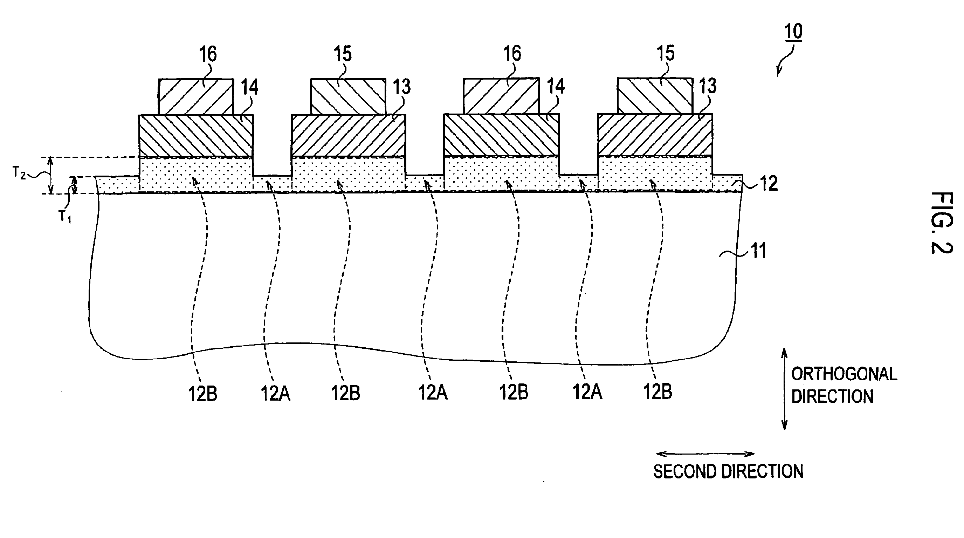

configuration of a solar cell 10 according to an embodiment of the present invention will be described with reference to Fig. 1 and Fig. 2. Fig. 1 is a plan view of the solar cell 10 according to this embodiment which is viewed from a back surface side. Fig. 2 is an enlarged cross-sectional view taken along an A-A line in Fig. 1.

As shown in Fig. 1 and Fig. 2, the solar cell 10 includes a semiconductor substrate 11, an i-type amorphous semiconductor layer 12, a p-type amorphous semiconductor layer 13, an n-type amorphous semiconductor layer 14, a p-side electrode 15 and an n-side electrode 16.

The semiconductor substrate 11 has a light receiving surface which receives sunlight and a back surface provided on an opposite side of the light receiving surface. The semiconductor substrate 11 generates photogenerated carriers by light reception on the light receiving surface. The photogenerated carriers are holes and electrons generated from the light absorbed by the semiconductor substrate 11.

The semiconductor substrate 11 has a conductive type of either an n-type or a p-type, which can be made of general semiconductor materials including crystalline semiconductor materials such as single-crystal Si or polycrystalline Si and compound semiconductor materials such as GaAs or InP. Here, tiny irregularities (textures) may be formed on the light receiving surface and the back surface of the semiconductor substrate 11.

The i-type amorphous semiconductor layer 12 is the substantially intrinsic amorphous semiconductor layer formed by either adding no dopant or adding a very small amount of dopant. As shown in Fig. 1, the i-type amorphous semiconductor layer 12 is formed so as to cover the almost entire back surface of the semiconductor substrate 11. The i-type amorphous semiconductor layer 12 has passivation property to suppress recombination of the carriers on the back surface of the semiconductor substrate 11.

In this embodiment, the i-type amorphous semiconductor layer 12 includes exposed portions 12A which are exposed outside the p-type amorphous semiconductor layer 13 and the n-type amorphous semiconductor layer 14, and covered portions 12B which are covered with the p-type amorphous semiconductor layer 13 and the n-type amorphous semiconductor layer 14, in a planer view from the back surface side of the semiconductor substrate 11. Specifically, as shown in Fig. 2, the p-type amorphous semiconductor layer 13 and the n-type amorphous semiconductor layer 14 are formed on the covered portions 12B. On the other hand, the p-type amorphous semiconductor layer 13 and the n-type amorphous semiconductor layer 14 are not formed on the exposed portions 12A, and the exposed portions 12A are exposed in the planer view as shown in Fig. 1. The exposed portions 12A and the covered portions 12B are formed into line shapes along a first direction on the back surface of the semiconductor substrate 11. Moreover, the exposed portions 12A and the covered portions 12B are alternately formed along a second direction which is substantially orthogonal to the first direction.

Here, in an orthogonal direction which is orthogonal to the back surface of the semiconductor substrate 11, a first thickness T₁ being the thickness of the exposed portions 12A is less than a second thickness T₂ being the thickness of the covered portions 12B. Therefore, a cut surface of the i-type amorphous semiconductor layer 12 has an irregular shape as shown in Fig. 2.

Note that the first thickness T₁ of the exposed portions 12A is preferably 1.44 nm or more but less than 25 nm, as will be described later. Meanwhile, a ratio (T₁/T₂) of the first thickness T₁ of the exposed portions 12A relative to the second thickness T₂ of the covered portions 12B is preferably 0.48 or more but less than 1.

The p-type amorphous semiconductor layer 13 is the amorphous semiconductor layer which is formed by adding p-type dopant. The p-type amorphous semiconductor layer 13 is formed on the covered portions 12B and into a line shape along the first direction. As described above, the structure (a HIT structure) configured to interpose the substantially intrinsic i-type amorphous semiconductor layer 12 (the covered portions 12B) between the semiconductor substrate 11 and the p-type amorphous semiconductor layer 13 can improve a p-n junction property.

The n-type amorphous semiconductor layer 14 is the amorphous semiconductor layer which is formed by adding n-type dopant. The n-type amorphous semiconductor layer 14 is formed on the covered portions 12B and into a line shape along the first direction. As described above, the structure (a BSF structure) configured to sequentially stack the i-type amorphous semiconductor layer 12 and the n-type amorphous semiconductor layer 14 on the back surface of the semiconductor substrate 11 can suppress recombination of the carriers on the back surface of the semiconductor substrate 11 effectively.

The p-side electrode 15 is a collector electrode configured to collect the holes gathering on the p-type amorphous semiconductor layer 13. The p-side electrode 15 is formed on the p-type amorphous semiconductor layer 13 and into a line shape along the first direction. The p-side electrode 15 can be formed by printing conductive paste of a resin type or a sintering type, for example.

The n-side electrode 16 is a collector electrode configured to collect the electrons gathering on the n-type amorphous semiconductor layer 14. The n-side electrode 16 is formed on the n-type amorphous semiconductor layer 14 and into a line shape along the first direction. The n-side electrode 16 can be formed in the same manner as the p-side electrode 15.

Here, each solar cell 10 having the above-described configuration outputs power of only approximately several watts. Accordingly, a solar cell module which is formed by electrically connecting multiple solar cells 11 to increase the output is employed when the solar cells 10 is used as a power source. To be more precise, one solar cell 10 is electrically connected to another solar cell 10 by connecting the p-side electrode 15 of the one solar cell 10 to the n-side electrode 16 of the other solar cell 10 with a wiring material.

### (Method of Manufacturing Solar Cell)

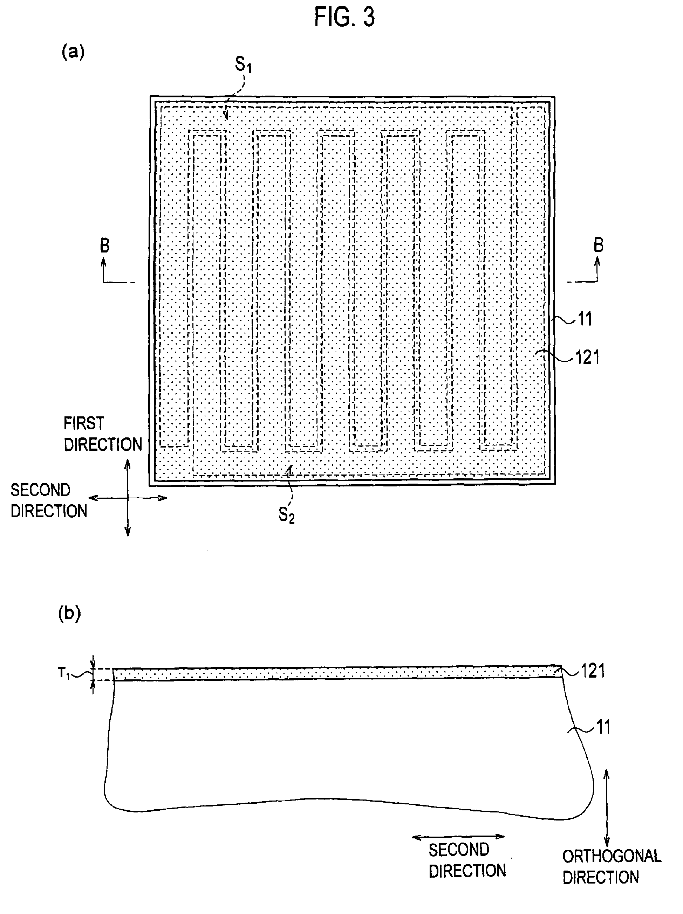

Next, a method of manufacturing the solar cell 10 will be described with reference to Fig. 3 to Fig. 5. Note that part (a) in each of these drawings is a plan view of the semiconductor substrate 11 viewed from the back surface side.

First, as shown in Fig. 3(a), a substantially intrinsic first i-type amorphous semiconductor layer 121 is formed on the almost entire back surface of the semiconductor substrate 11 by use of a CVD method. As shown in Fig. 3(b), the first i-type amorphous semiconductor layer 121 has the first thickness T₁ in the orthogonal direction, i.e., in the thickness direction. Note that Fig. 3(b) is an enlarged cross-sectional view taken along a B-B line in Fig. 3(a).

Next, a region on a surface of the first i-type amorphous semiconductor layer 121 excluding a first region S₁ and a second region S₂ shown in Fig. 3(a) is covered with a shadow mask.

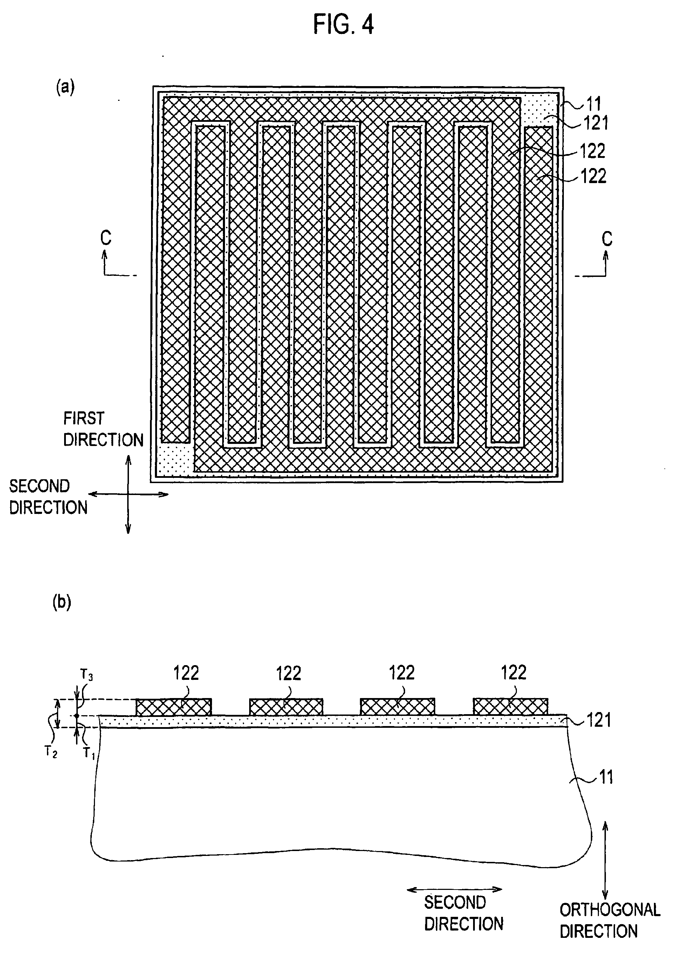

Next, as shown in Fig. 4(a), a substantially intrinsic second i-type amorphous semiconductor layer 122 is formed on the first region S₁ and the second region S₂ of the surface of the first i-type amorphous semiconductor layer 121 by use of the CVD method. In this way, the i-type amorphous semiconductor 12 including the exposed portions 12A and the covered portions 12B is formed. Here, as shown in Fig. 4(b), the second i-type amorphous semiconductor layer 122 has a third thickness T₃ in the orthogonal direction. A sum of the first thickness T₁ and the third thickness T₃ is the second thickness T₂ of the covered portions 12B (see Fig. 2). Note that Fig. 4(b) is an enlarged cross-sectional view taken along a C-C line in Fig. 4(a).

Next, a region on the surface of the first i-type amorphous semiconductor layer 121 excluding the second i-type amorphous semiconductor layer 122 formed on the first region S₁ is covered with a shadow mask. Subsequently, the p-type amorphous semiconductor layer 13 is formed on the second i-type amorphous semiconductor layer 122 formed on the first region S₁ by use of the CVD method. The thickness of the p-type amorphous semiconductor layer 13 is about 10 nm, for example.

Thereafter, a region on the surface of the first i-type amorphous semiconductor layer 121 excluding the second i-type amorphous semiconductor layer 122 formed on the second region S₂ is covered with a shadow mask. Subsequently, the n-type amorphous semiconductor layer 14 is formed on the second i-type amorphous semiconductor layer 122 formed on the second region S₂ by use of the CVD method. The thickness of the n-type amorphous semiconductor layer 14 is about 10 nm, for example.

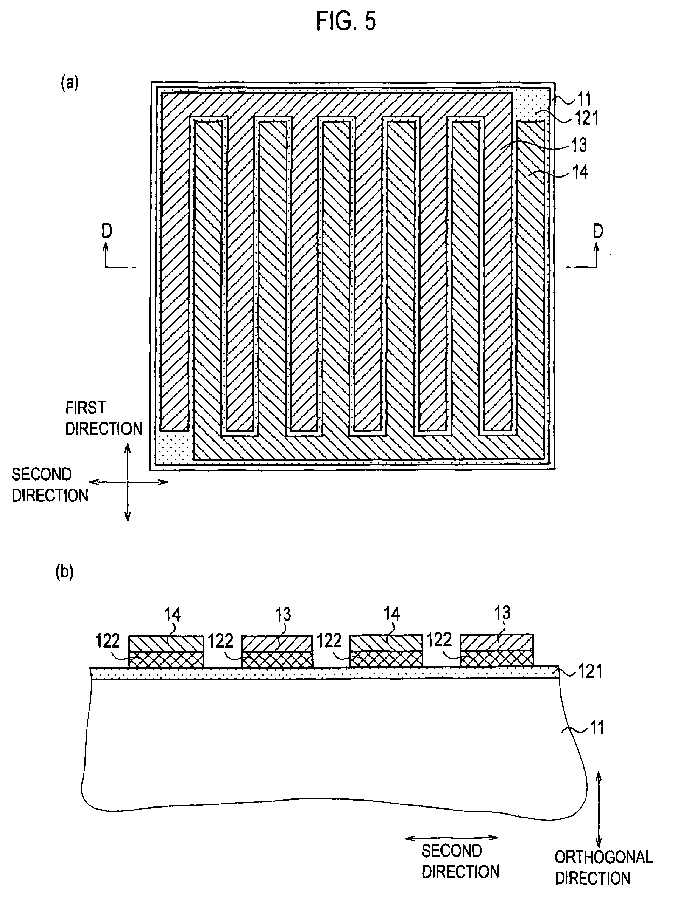

In this way, the "HIT structure" and the "BSF structure" are formed on the back surface of the semiconductor substrate 11 as shown in Figs. 5(a) and 5(b). Note that Fig. 5(b) is an enlarged cross-sectional view taken along a D-D line in Fig. 5(a).

Next, the p-side electrode 15 is formed on the p-type amorphous semiconductor layer 13 and the n-side electrode 16 is formed on the n-type amorphous semiconductor layer 14 by use of a printing method, a coating method or the like.

### (Appropriate Range of Thickness of Covered Portions)

Next, a verification experiment conducted for obtaining an appropriate range of the second thickness T₂ of the covered portions 12B will be described. Specifically, samples of the i-type amorphous semiconductor layer whose quality and layer thicknesses are changed within practicable ranges are fabricated, and solar cell characteristics (output values Pmax) of the samples are measured. Here, each of the samples is formed into the same thickness of the i-type amorphous semiconductor layer. Note that the i-type amorphous semiconductor layer has higher quality if there are fewer defects contained inside the layer or if electric conductivity thereof is lower.

### 1. Sample Group A

A sample group A is a group of solar cells including a high-quality i-type amorphous Si layer as a passivation layer. Specifically, the i-type amorphous Si layer is formed by setting conditions of a CVD apparatus as a SiH₄ flow rate of 50 sccm, a H₂ flow rate of 80 sccm, a pressure at 80 Pa, a temperature at 180°C, and a RF power of 50 W.

The sample group A includes the samples having six types of different thicknesses in a layer thickness range from 2 nm to 26 nm.

### 2. Sample Group B

A sample group B is a group of solar cells including a medium-quality i-type amorphous Si layer as a passivation layer. Specifically, the i-type amorphous Si layer is formed by setting conditions of a CVD apparatus as a SiH₄ flow rate of 50 sccm, a H₂ flow rate of 80 sccm, a pressure at 80 Pa, a temperature at 180°C, and a RF power of 100 W.

The sample group B includes the samples having six types of different thicknesses in a layer thickness range from 2 nm to 32 nm.

### 3. Sample Group C

A sample group C is a group of solar cells including a low-quality i-type amorphous Si layer as a passivation layer. Specifically, the i-type amorphous Si layer is formed by setting conditions of a CVD apparatus as a SiH₄ flow rate of 50 sccm, a H₂ flow rate of 80 sccm, a pressure at 80 Pa, a temperature at 180°C, and a RF power of 200 W.

The sample group C includes the samples having six types of different thicknesses in a layer thickness range from 14 nm to 38 nm.

### 4. Measurement Results of Solar Cell Characteristics

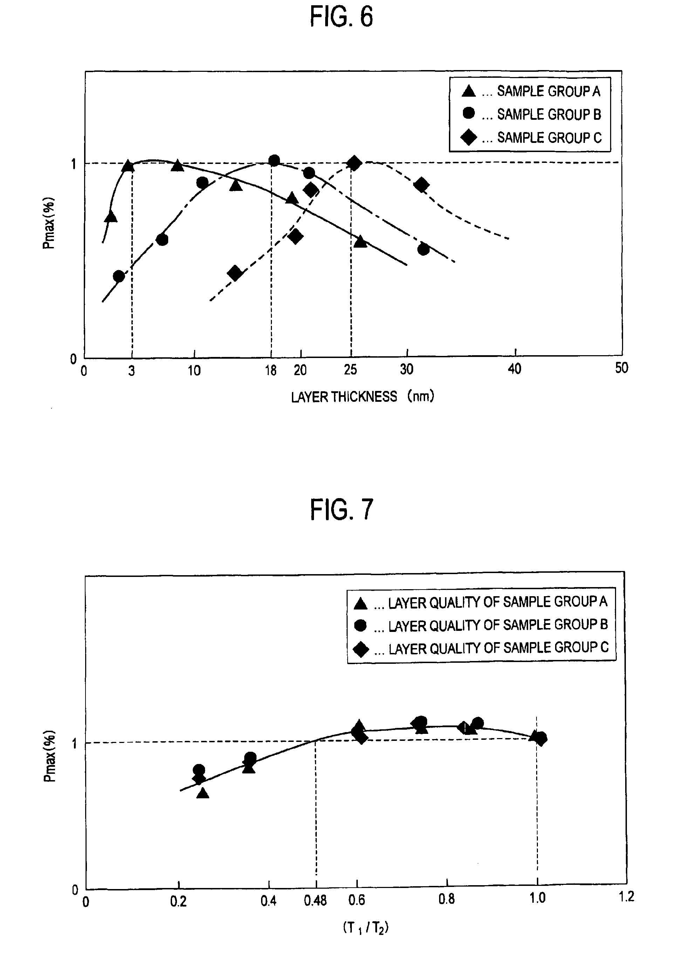

Fig. 6 is a graph showing relations between the layer thicknesses and solar cell characteristics (the output values Pmax) regarding the sample groups A to C.

As shown in Fig. 6, peaks of the solar cell characteristics are obtained from the sample group A including the i-type amorphous Si layer in the layer thickness of 3 nm, the sample group B including the i-type amorphous Si layer in the layer thickness of 18 nm, and the sample group C including the i-type amorphous Si layer in the layer thickness of 25 nm.

Therefore, it is found that the favorable solar cell characteristic can be obtained by forming the i-type amorphous Si layer having the practicable quality while setting the layer thickness of the i-type amorphous Si layer in the range of 3 nm to 25 nm both inclusive. Hence, it is understood that the appropriate range of the second thickness T₂ of the covered portions 12B according to this embodiment is from 3 nm to 25 nm both inclusive.

### (Appropriate Range of Ratio of First Thickness T₁ Relative to Second Thickness T₂)

Next, a verification experiment conducted for obtaining an appropriate range of the ratio (T₁/T₂) of the first thickness T₁ of the exposed portions 12A relative to the second thickness T₂ of the covered portions 12B will be described. Specifically, samples including the exposed portions 12A and the covered portions 12B which are formed with quality (setting condition) of the above-described sample groups A to C are fabricated, and solar cell characteristics (the output values Pmax) of the samples are measured.

Fig. 7 is a graph showing relations between the ratios (T₁/T₂) of the first thickness T₁ relative to the second thickness T₂ and the solar cell characteristics (the output values Pmax) regarding the samples.

As shown in Fig. 7, it is confirmed that there are correlations between the ratios (T₁/T₂) and the solar cell characteristics (the output values Pmax) irrespective of the layer quality. Moreover, it is found that it is possible to obtain an output value Pmax higher than that of the case where the layer thickness of the i-type amorphous Si layer is uniform, as long as the ratio (T₁/T₂) is 0.48 or more but less than 1.0 as shown in Fig. 7. The reason of this result is that a sufficient passivation property of the i-type amorphous Si layer cannot be achieved if the ratio (T₁/T₂) is less than 0.48.

Here, as described previously, the appropriate range of the second thickness T₂ of the covered portions 12B is from 3 nm to 25 nm both inclusive. Accordingly, in consideration of 0.48 ≤ (T₁/T₂) < 1.0, the appropriate range of the first thickness T₁ of the exposed portions 12A is 1.44 nm or more but less than 25 nm.

### (Advantageous Effects)

In the solar cell 10 according to this embodiment, the i-type amorphous semiconductor layer 12 includes the exposed portions 12A exposed in the planer view and the covered portions 12B covered with the p-type amorphous semiconductor layer 13 and the n-type amorphous semiconductor layer 14. In the orthogonal direction, the first thickness T₁ of the exposed portions 12A is less than the second thickness T₂ of the covered portions 12B.

Therefore, in a parallel direction to the back surface of the semiconductor substrate 11, electrical resistance of the exposed portion 12A can be made larger than electrical resistance of the covered portion 12B. For this reason, occurrence of a short circuit can be suppressed between the p-type amorphous semiconductor layer 13 formed on one covered portion 12B and the n-type amorphous semiconductor layer 14 formed on another covered portion 12B.

Moreover, there are formed not only the covered portions 12B but also the exposed portions 12A on the back surface of the semiconductor substrate 11. For this reason, the passivation property of the i-type amorphous semiconductor layer 12 can be maintained on the back surface of the semiconductor substrate 11.

Here, as confirmed in the above-described verification experiments, the ratio (T₁/T₂) of the first thickness T₁ of the exposed portions 12A relative to the second thickness T₂ of the covered portions 12B is preferably 0.48 or more but less than 1.0. Moreover, the first thickness T₁ of the exposed portions 12A is preferably 1.44 nm or more but less than 25 nm.

Meanwhile, the method of manufacturing the solar cell 10 according to this embodiment includes the steps of forming the first i-type amorphous semiconductor layer 121 on the back surface of the semiconductor substrate 11, forming the second i-type amorphous semiconductor layer 122 on the first region S1 and on the second region S2 on the first i-type amorphous semiconductor layer 121, and forming the p-type amorphous semiconductor layer 13 and the n-type amorphous semiconductor layer 14 on the second i-type amorphous semiconductor layer 122.

Therefore, the exposed portions 12A and the covered portions 12B can be easily formed without damaging the p-type amorphous semiconductor layer 13 and the n-type amorphous semiconductor layer 14.

### (Other Embodiments)

As described above, the details of the present invention have been disclosed by using the embodiment of the present invention. However, it should not be understood that the description and drawings which constitute part of this disclosure limit the present invention. From this disclosure, various alternative embodiments, examples, and operation techniques will be easily found by those skilled in the art.

For example, in the above-described embodiment, the number and shapes of the p-type amorphous semiconductor layer 13 and the n-type amorphous semiconductor layer 14 are merely schematic, and are not limited only thereto. The number and shapes of the p-type amorphous semiconductor layer 13 and the n-type amorphous semiconductor layer 14 can be set appropriately based on the size of the semiconductor substrate 11 and other factors.

Meanwhile, the above-described embodiment is configured to form the amorphous semiconductor layers on the covered portions 12B. However, the semiconductor layers formed on the covered portions 12B may be of any of polycrystalline, microcrystalline, and amorphous properties.

Meanwhile, in the above-described embodiment, the i-type amorphous semiconductor layer 12 is formed by sequentially stacking the first i-type amorphous semiconductor layer 121 and the second i-type amorphous semiconductor layer 122. However, the invention is not limited only thereto. For example, the exposed portions 12A having the first thickness T₁ may be formed by forming an i-type amorphous semiconductor layer with the uniform second thickness T₂ on the back surface of the semiconductor substrate 11 and then subjecting the region excluding the first region S₁ and the second region S₂ to laser irradiation or an etching process.

Meanwhile, although it is not particularly mentioned in the above-described embodiment, a transparent conductive film (TCO) may be interposed between the p-side electrode 15 and the covered portion 12B as well as between the n-side electrode 16 and the covered portion 12B.

Further, although it is not particularly mentioned in the above-described embodiment, an antireflection film may be formed on the light receiving surface of the semiconductor substrate 11. In this way, photoelectric conversion efficiency of the solar cell 10 can be improved.

It is to be noted that the entire contents of Japanese Patent Application No. 2008-171323 (filed on June 30, 2008) are incorporated in this specification by reference.

### Industrial Applicability

As described above, the back-junction solar cell and the method of manufacturing the same according to the present invention can suppress occurrence of a short circuit on the amorphous semiconductor layer formed on the back surface of the semiconductor substrate, and thus are advantageous to photovoltaic power generation.

## Claims

1. A solar cell comprising:
a semiconductor substrate having a light receiving surface and a back surface provided on an opposite side of the light receiving surface;
a amorphous semiconductor layer, substantially intrinsic, and formed on the back surface;
a p-type semiconductor layer formed on the amorphous semiconductor layer; and
an n-type semiconductor layer formed on the amorphous semiconductor layer, wherein
the amorphous semiconductor layer includes an exposed portion exposed in a planer view from the back surface side, and a covered portion covered with each of the p-type semiconductor layer and the n-type semiconductor layer in the planer view, and
a first thickness being a thickness of the exposed portion is less than a second thickness being a thickness of the covered portion.

2. The solar cell according to claim 1, wherein
a ratio of the first thickness relative to the second thickness is 0.48 or more but less than 1.

3. The solar cell according to claim 1, wherein
the first thickness is 1.44 nm or more but less than 25 nm.

4. A method of manufacturing a solar cell which includes a semiconductor substrate having a light receiving surface and a back surface provided on an opposite side of the light receiving surface, the method comprising the steps of:
forming a first amorphous semiconductor layer substantially intrinsic on the back surface;
forming a second amorphous semiconductor substantially intrinsic on a first region and on a second region provided in a surface of the first amorphous semiconductor layer;
forming a p-type semiconductor layer on the second amorphous semiconductor layer formed on the first region; and
forming an n-type semiconductor layer on the second amorphous semiconductor layer formed on the second region.
